# EUROPEAN PATENT APPLICATION

(11) **EP 4 571 838 A1**
(43) Date of publication of application: **18.06.2025**
(21) Application number: 23216342.8
(22) Date of filing: 13.12.2023
(51) Int. Cl.: H01L 29/06, H01L 29/24, H01L 21/334, H01L 29/778, H01L 29/417

(54) **2D CHANNEL FIELD-EFFECT TRANSISTOR DEVICE**

(71) Applicant: IMEC VZW, 3001 Leuven (BE)
(72) Inventor: MORIN, Pierre, 1150 Woluwe-Saint-Pierre (BE)
(74) Representative: Lind Edlund Kenamets Intellectual Property AB

(57) **Abstract**

There is provided a method for forming a 2D channel field-effect transistor device (10). The method comprising: forming a device structure (100) comprising: a device layer stack (103) comprising a channel layer (104) of a 2D material and a pair of sacrificial layers (106) of a sacrificial material, wherein the channel layer is arranged between the pair of sacrificial layers (106), source/drain contacts (134) in contact with source/drain contact portions (104) of the channel layer (104) on either side of a channel region (105), and
an insulating layer (130) embedding the device layer stack (103) and the source/drain contacts (134); forming a gate cavity (142) exposing the channel layer (104) and the sacrificial layers (106) along the channel region (105); removing the sacrificial layers (106) along the channel region (105) by selectively etching the sacrificial material from the gate cavity (142), thereby extending the gate cavity (142) into the device layer stack (103) between the source/drain contacts; forming an inner spacer (150) by depositing an inner spacer material on interior surfaces exposed in the gate cavity (142) using an area selective deposition process, wherein surface portions (104b) of the channel layer (104) exposed in the gate cavity (142) define deposition-inhibiting areas for the selective deposition process; and forming a gate stack (160) in the gate cavity (142), the gate stack (160) surrounding the channel layer (104) along the channel region (105) and comprising a gate dielectric (164) and one or more gate metal layers (162), wherein the gate stack (160) is laterally separated from the source/drain contacts (134) by the inner spacer (150).

## Description

### TECHNICAL FIELD

The present invention generally relates to a method for forming a 2D channel field-effect transistor device.

### BACKGROUND

Modern semiconductor and integrated circuit technology includes horizontal channel transistors, for example the horizontal or lateral nanosheet FET (NSHFET). A NSHFET includes a source, a drain, a channel comprising one or more nanosheet-shaped horizontally extending channel layers and a gate stack. In a gate-all-around (GAA) design, the gate stack wraps all-around the channel layers.

Fabrication methods for NSHFET devices is typically based on processing of a semiconductor layer stack of alternating sacrificial layers and channel layers patterned into a nanosheet shape.

The processing may subsequent to source/drain epitaxy and prior to gate stack deposition comprise a step of etching away sacrificial layer material above and below the channel layers to form "released" channel layers, such that the gate stack subsequently may be formed to surround the channel layers. Preceding the channel release, so-called "inner spacers" are typically formed on end surfaces of the sacrificial layers by laterally recessing the sacrificial layers from both sides of the sacrificial gate, and filling the recesses with a dielectric material. The inner spacers may thus during the subsequent channel release step mask the source/drain regions from the etching. The inner spacers may further provide physical and electrical separation between the source/drain regions and the gate metal in the final device and thus reduce parasitic capacitance.

In the strive to provide more efficient horizontal channel transistors, other materials (than the traditionally used silicon) are constantly evaluated as candidate materials for the channel layers of future generations of such transistors. A promising group of candidate materials for the channel layers are 2D materials. 2D materials, such as transition metal dichalcogenides (TMDs or MX2, where M is a metal such as W or Mo, and where X is a chalcogen such as sulfur or selenide) offer several advantages when compared to traditional three-dimensional bulk materials like silicon. For instance, enabling very thin channel layers (e.g., a few monolayers), high electron mobility, precise thickness control, favorable on-off ratios, to name a few.

### SUMMARY

Despite the highly appealing properties of 2D material as a channel material in NSHFETs, 2D materials are generally more delicate and hence more prone to being damaged during processing than silicon. Hence, traditional processing techniques used during fabrication of silicon-based devices may not always be suitable for forming 2D channel FETs. As realized by the inventor, presence of channel layers of a 2D material may in particular complicate inner spacer formation. This since 2D material channel layers may be more prone to getting damaged during inner spacer formation, especially during inner spacer liner deposition (may induce defects in the 2D material), as well as during inner spacer liner etch back (potentially damaging and thus degrading the 2D material).

It is thus an object of the present invention to provide a method for forming a 2D channel field-effect transistor device which solves or at least alleviates at least some of the above drawbacks related to the fabrication.

Hence, it is an object to provide a method for forming a 2D channel field-effect transistor device by which the inner spacer may be formed with a reduced risk of defect formation or damage to the 2D material channel layers.

Another object is to provide a method for forming a 2D channel field-effect transistor device by which the yield may be improved.

These and other objects may be achieved by a method for forming a 2D channel field-effect transistor device in accordance with the independent claim. Embodiments of the present invention are defined in the dependent claims.

Hence, according to an aspect of the present invention, there is provided a method for forming a 2D channel field-effect transistor device, the method comprising:
forming a device structure comprising:
   a device layer stack comprising a channel layer of a 2D material and a pair of sacrificial layers of a sacrificial material, wherein the channel layer is arranged between the pair of sacrificial layers,
   source/drain contacts in contact with source/drain contact portions of the channel layer on either side of a channel region, and
   an insulating layer embedding the device layer stack and the source/drain contacts;
forming a gate cavity exposing the channel layer and the sacrificial layers along the channel region;
removing the sacrificial layers along the channel region by selectively etching the sacrificial material from the gate cavity, thereby extending the gate cavity into the device layer stack between the source/drain contacts;
forming an inner spacer by depositing an inner spacer material on interior surfaces exposed in the gate cavity using an area selective deposition process, wherein surface portions of the channel layer exposed in the gate cavity define deposition-inhibiting areas for the selective deposition process; and
forming a gate stack in the gate cavity, the gate stack surrounding the channel layer along the channel region and comprising a gate dielectric and one or more gate metal layers, wherein the gate stack is laterally separated from the source/drain contacts by the inner spacer.

Thus, by the present method aspect, the inner spacer is formed from within the gate cavity after the source/drain contacts have been formed in contact with source/drain contact portions of the channel layer on either side of the channel region. Thereby, exposing the source/drain contact portions of the channel layer to the inner spacer liner deposition applied in the conventional inner spacer formation approaches may be avoided. Additionally, etch back of the inner spacer to reveal source/drain contact portions of the channel layer on either side of a channel region may be omitted. In this way, defect formation and/or damage to the source/drain contact portions of the channel layer during inner spacer formation may be prevented or counteracted.

Moreover, contact between the source/drain contact portions of the channel layer and the source/drain contacts may be established prior to forming the gate cavity. Thus, the source/drain contacts may protect the source/drain contact portions of the channel layer during inner spacer formation, thereby preventing or counteracting that the inner spacer formation influences the contact between the source/drain contact portions of the channel layer and the source/drain contacts.

Further, by forming the inner spacer by depositing an inner spacer material on interior surfaces exposed in the gate cavity using an area selective deposition process, wherein surface portions of the channel layer exposed in the gate cavity define deposition-inhibiting areas for the selective deposition process, the inner spacer may be formed only or predominantly at desired locations in the gate cavity. Hence, the inner spacer may not be formed on surface portions of the channel layer exposed in the gate cavity, resulting in that there may be no need to perform any kind of inner spacer etch back. In other words, the gate stack may be formed directly to surround the channel layer along the channel region. At the same time, the gate stack may be laterally separated from the source/drain contacts by the selectively deposited inner spacer. Hence, the gate stack may be separated from the source/drain contacts by the inner spacer as seen along the channel direction.

In some embodiments, the device layer stack comprises an alternating sequence of channel layers of the 2D material and sacrificial layers of the sacrificial material. That is, the device layer stack may comprise two or more channel layers. Each channel layer may be arranged between a respective pair of sacrificial layers. Accordingly, consistent with such embodiments, any reference to "the channel layer" in the following may be understood as a reference to any or each channel layer of the device layer stack.

By "gate cavity" is here meant a cavity which is formed adjacent to the device layer stack such that the channel layer and the sacrificial layers are exposed along the channel region via the gate cavity. In other words, the gate cavity will expose the channel layer (or each channel layer) and the sacrificial layers along the channel region from at least one sidewall thereof such that the layers of the device layer stack are accessible via the gate cavity.

By "extending the gate cavity" is here meant that the gate cavity is made larger by removing the sacrificial layers along the channel region via the gate cavity. In this way, the "extended" gate cavity will extend above and below the channel layer, meaning that the extended gate cavity additionally exposes horizontally oriented surfaces of the (thus released) channel layer and surface portions of the source/drain contacts facing the channel region.

According to some embodiments, the method may further comprise forming recesses in the device layer stack by laterally etching back the sacrificial layers from opposite sides of the channel region prior to forming the source/drain contacts. Hereby the source/drain contacts may be formed to wrap around the source/drain contact portions. Hence, the contact surface between the source/drain contact portions of the channel layer (or each channel layer) and the source/drain contacts may be enlarged. In this way, an improved contact between the source/drain contact portions and the source/drain contacts may be established.

According to some embodiments, the gate cavity may expose the device layer stack along one sidewall, or two opposite sidewalls, of the device layer stack.

By the gate cavity exposing the device layer stack along one sidewall, the gate cavity may be extended into the device layer stack between the source/drain contacts such that the gate cavity may expose three sides of the channel layer of the device layer stack. Hence, the gate stack may be formed to straddle the channel layer (or each channel layer) of the device layer stack along the channel region.

By the gate cavity exposing the device layer stack along two opposite sidewalls, the gate cavity may be extended into the device layer stack between the source/drain contacts such that all (four) sides of the channel layer (or each channel layer) may be exposed. Hence, the gate stack may be formed to completely wrap around the channel layer (or each channel layer) along the channel region.

According to some embodiments, the device structure may further comprise a sacrificial gate body extending across the device layer stack in the channel region, wherein forming the gate cavity may comprise removing the sacrificial gate body. Thereby, the gate cavity may be formed in a self-aligned manner with respect to the channel region. Hence, the gate cavity may be formed such that the extension of the gate cavity corresponds to at least a portion of the removed sacrificial gate body. In practice, the gate cavity may be formed such that the extension of the gate cavity corresponds to a removed portion or to removed portions of the sacrificial gate body arranged adjacent to the device layer stack such that the channel layer and the sacrificial layers are exposed along the channel region. Further, by the device structure comprising a sacrificial gate body extending across the device layer stack in the channel region, wherein forming the gate cavity comprises removing the sacrificial gate body, an accurate positioning of the gate stack may be provided without any dedicated alignment steps. In other words, the gate cavity may be formed at the location of the sacrificial gate body by selectively removing the sacrificial gate body.

According to some embodiments, forming the device structure may comprise:
forming a fin-shaped initial device layer stack comprising a channel layer of the 2D material and a pair of sacrificial layers of the sacrificial material, wherein the channel layer is arranged between the pair of sacrificial layers;
forming a sacrificial gate structure across the initial device layer stack, the sacrificial gate structure comprising the sacrificial gate body;
forming source/drain contact cavities on either side of the channel region using the sacrificial gate structure as an etch mask such that a portion of the initial device layer stack remains in the channel region to form the device layer stack; and
forming the source/drain contacts in the source/drain cavities.

A length dimension of the initial device layer stack (i.e., a dimension of the channel region) may hence be defined using the sacrificial gate structure.

The fin-shaped initial device layer stack may in particular comprise an alternating sequence of channel layers of the 2D material and sacrificial layers of the sacrificial material.

According to some embodiments, forming the gate cavity may comprise etching the insulating layer adjacent the device layer stack. Hereby, a sidewall of the device layer stack may be accessed through the gate cavity via an etching process.

According to some embodiments, forming the device structure may comprise:
forming a fin-shaped initial device layer stack comprising a channel layer of the 2D material and a pair of sacrificial layers of the sacrificial material, and a hard mask as a top layer, wherein the channel layer is arranged between the pair of sacrificial layers;
forming the insulating layer to embed the initial device layer stack;
patterning the hard mask to open the hard mask on either side of the channel region;
forming source/drain contact cavities on either side of the channel region using the patterned hard mask as an etch mask such that a portion of the initial device layer stack remains in the channel region to form the device layer stack; and
forming the source/drain contacts in the source/drain cavities.

The fin-shaped initial device layer stack may in particular comprise an alternating sequence of channel layers of the 2D material and sacrificial layers of the sacrificial material.

According to some embodiments, forming the gate cavity may further comprise removing the patterned hard mask. This allows for that the gate stack may extend above the level of a bottom surface of the hard mask. In other words, the gate stack may be made thicker above the (uppermost) channel layer.

According to some embodiments, the patterned hard mask may remain on the device layer stack while forming the gate cavity. This allows for that the height of the gate stack may be defined or controlled by the thickness of the hard mask.

According to some embodiments, the 2D material may be a transition metal dichalcogenide.

### BRIEF DESCRIPTION OF THE DRAWINGS

This and other aspects of the present invention will now be described in more detail, with reference to the appended drawings showing embodiments of the present invention.
Figs. 1-7 schematically show a device structure at different stages of a method for forming a 2D channel field-effect transistor device, according to various embodiments.
Fig. 8-14 schematically show an alternative device structure at different stages of a method for forming a 2D channel field-effect transistor device, according to various embodiments.

### DETAILED DESCRIPTION

Hereafter follows a detailed description of various method embodiments for forming a 2D channel field-effect transistor device. More specifically, the methods comprise forming an inner spacer from within the gate cavity after the source/drain contacts have been formed in contact with source/drain contact portions of the channel layer or channel layers on either side of a channel region. The methods will be described with reference to the drawings.

The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a substrate of the 2D channel field-effect transistor device being formed. The term "vertical" refers to a direction parallel to a normal direction of (a main surface of) a substrate which in practice supports the 2D channel field-effect transistor device, i.e., transverse to the substrate. Further, the (positive) vertical direction refers to a direction which points out of what typically is regarded as a front side of the substrate. This means that subsequent layers of the device layer stack are arranged one after the other in the vertical direction and hence in the direction indicated by the axis Z.

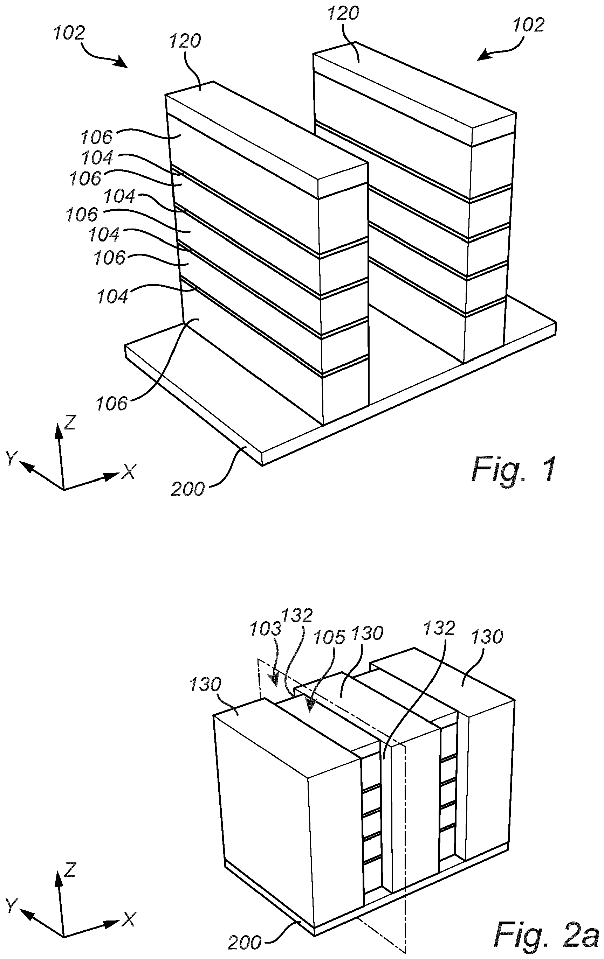

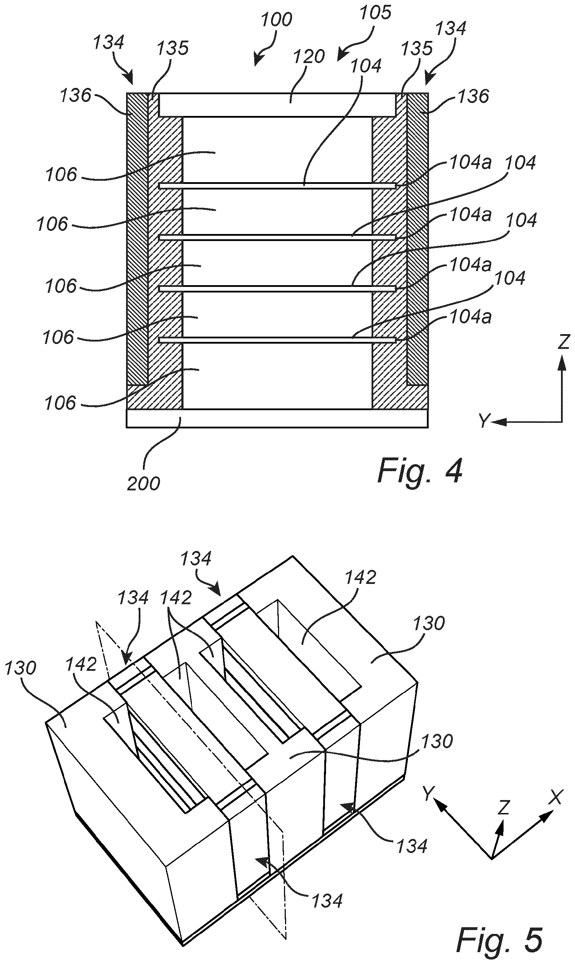

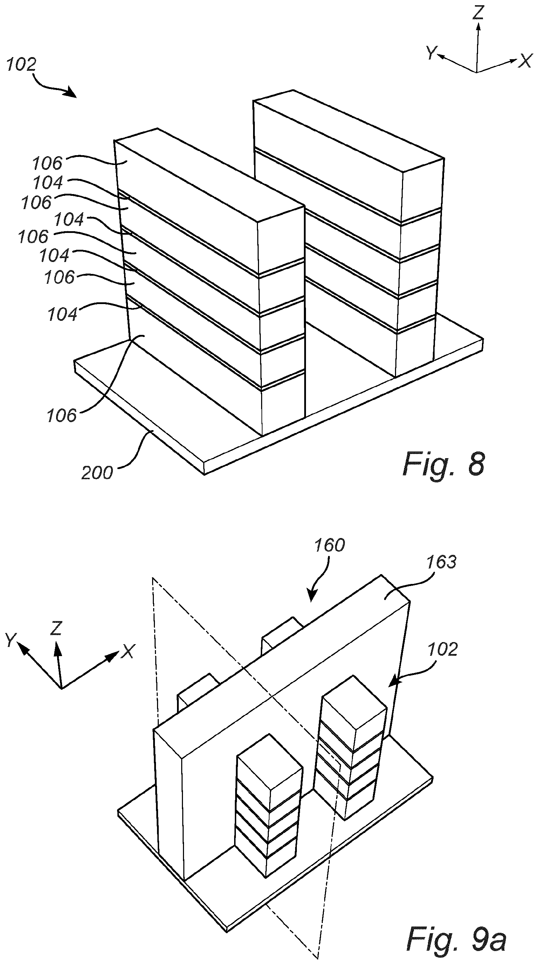

Initially it will be described with reference to Figs. 1-4 how a device structure 100 according to embodiments may be formed. The device structure 100 is then processed further to form a 2D channel field-effect transistor device 10. Thereafter, it will be described with reference to Figs. 5-7 how the 2D channel field-effect transistor device 10 may be formed from the device structure 100. Followingly, alternative embodiments of the method will be described with reference to Figs. 8-14.

Fig. 1 schematically shows a perspective view of a pair of parallelly extending fin-shaped initial device layer stacks 102 and a substrate 200. The substrate 200 may be a conventional semiconductor substrate suitable for complementary FETs. The substrate 200 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

In the following, one of the fin-shaped initial device layer stacks 102 of Fig. 1 will be described in greater detail, although the following description is equally applicable for the other fin-shaped initial device layer stack 102 of Fig. 1. However, in practice, when forming 2D channel field-effect transistor devices of the described kind, a multitude of devices are typically formed in parallel. Hence, the method embodiments are typically performed on a multitude of fin-shaped initial device layer stacks 102 in parallel.

The depicted fin-shaped initial device layer stack 102 of Fig. 1 comprises an alternating sequence of channel layers 104 of a 2D material and sacrificial layers 106 of a sacrificial material. The fin-shaped initial device layer stack 102 further comprises a hard mask layer 120 as a top layer. The depicted fin-shaped initial device layer stack 102 may be formed by alternatingly growing layers of the 2D material and the sacrificial material such that an alternating sequence of channel layers 104 of the 2D material and sacrificial layers 106 of the sacrificial material is obtained. The layer stack may then be patterned into a fin-shaped structure as shown in Fig. 1. Any conventional single- or multiple-patterning techniques used for fin patterning may be used. The 2D material may be a transition metal dichalcogenide, such as molybdenum disulfide, tungsten disulfide, molybdenum diselenide or tungsten diselenide. The 2D material may be formed by chemical vapor deposition (CVD). The sacrificial layer may be dummy dielectric such as, SiO₂, AlN, SiN, TiN, Al₂O₃ or a combination thereof. The sacrificial layer may be deposited by CVD or atomic layer deposition (ALD). The hard mask layer 120 may be of a conventional type used for fin patterning, for example a nitride- or oxide-based hard mask layer or a combination deposited on top of the fin shaped initial device layer stack 102 by for instance CVD or ALD.

Now turning also to Fig. 2a. Here it is depicted how the fin-shaped initial device layer stack 102 of Fig. 1 has been subjected to a sequence of processing steps. Initially, an insulating layer 130 has been formed to embed the initial device layer stack 102 of Fig. 1. The insulating layer 130 may be an oxide layer, such as silicon oxide or some other conventional low-k inter-layer dielectric (ILD).

Further, the fin-shaped initial device layer stack 102 of Fig. 1 has been subjected to a so-called fin cut. That is, the fin-shaped semiconductor structure 102 has been cut to a certain length, i.e. to define a certain channel length of the 2D channel field-effect transistor device being formed. In order to perform the fin cut, the hard mask 120 may be patterned to open the hard mask 120 on either side of a portion of the fin-shaped initial device layer stack 102 that is to remain as a channel region 105 of the 2D channel field-effect transistor device being formed. In other words, a pair of openings may be made in the hard mask 120 along the fin-shaped initial device layer stack 102 for each device that is to be formed along the structure 102. Thereafter, source/drain contact cavities 132 may be formed on either side of the portion of the initial device layer stack 102, that is to remain as the channel region 105. The source/drain contact cavities 132 of Fig. 2a may be formed using the patterned hard 120 mask as an etch mask such that the portion of the initial device layer stack remains in the channel region 105 to form a device layer stack 103.

Thus, by the fin cut, a fin-shaped device layer stack 103 comprising an alternating sequence of channel layers 104 of the 2D material and sacrificial layers 106 of the sacrificial material, and a hard mask 102 as a top layer is formed.

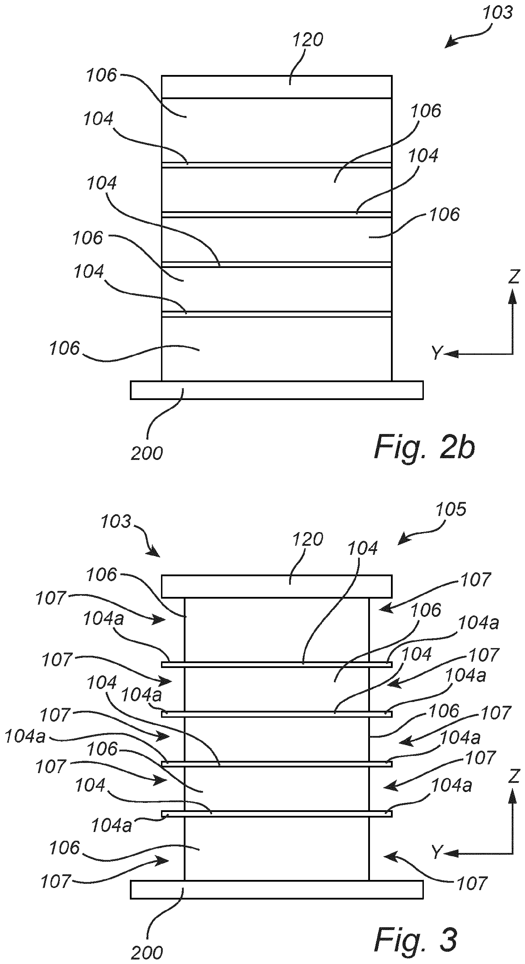

Now also turning to Fig. 2b. Fig 2b, schematically shows a cross sectional view through the fin-shaped device layer stack 103 of Fig. 2a along the Y-Z-plane generally indicated by a hatched plane in Fig. 2a. In Fig. 2b the alternating sequence of the channel layers 104 of the 2D material and the sacrificial layers 106 of the sacrificial material is clearly illustrated. It is further shown that the hard mask 120 remains as a top layer and that the alternating sequence of the channel layers 104 of the 2D material and the sacrificial layers 106 is provided on the substrate 200. It is to be noted that the number of channel layers 104 and sacrificial layers 106 of the device layer stack 103 shown in the figures, merely is an example and that both smaller and greater numbers of channel layers 104 and sacrificial layers 106 are possible. In general, the device layer stack 103 may comprise a pair of sacrificial layers 106 and a channel layer 104 arranged between the pair of sacrificial layers 106. Regardless of the number of channel and sacrificial layers 104, 106, a bottom-most layer of the device layer stack 103 may typically be a sacrificial layer 106.

Now also turning to Fig. 3. Fig 3, schematically shows the same cross section as depicted in Fig. 2b. However, in Fig. 3, the fin-shaped device layer stack 103 has been subjected to a further processing step, namely recesses 107 have been formed on either side in the device layer 103 stack. The recesses 107 may be formed by laterally etching back the sacrificial layers 106 from opposite sides of the channel region 105 as shown in Fig. 3. Hence, the recesses 107 may be formed by laterally etching back end surfaces of each sacrificial layer 106 of the device layer stack 103 from opposite sides thereof (e.g. along the Y- and negative Y-direction). The lateral etch back may be achieved by an isotropic etching process. Any suitable dry etching process or wet etching process allowing selective etching of the sacrificial material without causing any appreciable etch back of the channel layers may be used. For example, sacrificial layers 106 of SiO₂ and/or Al₂O₃ may be etched back selectively to the channel layers 104 using an HF-based etchant. By forming the recesses 107 prior to forming any source/drain contacts, protruding source/drain contact portions 104a of the channel layers 104 may be formed on either side of the channel region 105 as illustrated in Fig. 3.

Now also turning to Fig. 4. Fig. 4, schematically shows the same cross section as depicted in Fig. 3. However, in Fig. 4 the fin-shaped device layer stack 103 has been subjected to further processing steps. In Fig. 4 source/drain contacts 134 has been formed in the source/drain cavities 132. As illustrated in Fig. 4, by forming the recesses 107 prior to forming the source/drain contacts 134, the source/drain contacts 134 may be formed to wrap around source/drain contact portions 104a of the channel layers 104. However, the formation of the recesses 107 as described in conjunction with Fig. 3 may be omitted. In this way, source/drain contacts 134 may be formed in the source/drain cavities 132 such that the source drain contacts 134 contacts end surfaces of the channel layers 104 rather wrapping around contact portions 104a of the channel layers 104. Thus, the source/drain contacts 134 may be formed directly in the source/drain cavities 132 of Fig. 2a. The source/drain contacts 134 may as illustrated in Fig. 4 comprise a plurality of materials 135, 136 as depicted in Fig. 4. A contact metal layer 135 comprising Ti as a contact metal may be formed to wrap around the source/drain contact portions 104a of the channel layers 104 as illustrated in Fig. 4. Other examples of contact metals are Bi, Sb, Ni, Pd pure or alloyed. A remaining portion, i.e. a portion not filled by the contact metal layer 135, of the source drain cavities 132 may be filled by a fill metal plug 136 as illustrated in Fig. 4. Such fill metal plug 136 may for example comprise tungsten, aluminum, silver or gold. The contact metal(s) may be deposited using any suitable conventional deposition process, such as PVD, CVD and/or ALD. After deposition, overburden contact metal may be recessed by chemical mechanical polishing (CMP) and/or metal etch back to remove overburden metal, and thus arrive at the device structure as shown in Fig. 4.

To sum up, Fig. 4 shows a device structure 100. The device structure 100 of Fig. 4 comprises the device layer stack 103. The device layer stack comprises an alternating sequence of channel layers 104 of a 2D material and sacrificial layers 106 of a sacrificial material. The device structure 100 of Fig. 4 further comprises the source/drain contacts 134. The source/drain contacts 134 are arranged in contact with the source/drain contact portions 104a of the channel layers 104 on either side of the channel region 105. Further, the insulating layer 130 (visible e.g., in the perspective view of Fig. 5) embeds the device layer stack 103 and the source/drain contacts 134.

Now also turning to Fig. 5. Fig 5, schematically shows the device structure 100 depicted in Fig. 4 in a perspective view. However, in Fig. 5 the device structure 100 has been subjected to a sequence of processing steps. A gate cavity 142 has been formed for each device layer stack 103. As depicted in Fig. 5, each gate cavity 142 extends down in the -Z-direction on either side of the channel region 105. Hence, the gate cavity 142 exposes the channel layers 104 and the sacrificial layers 106 along the channel region 105 extending along the Y-axis. As shown in Fig. 5, the gate cavity 142 exposes the device layer stack 103 along two opposite sidewalls of the device layer stack 103. As an alternative, the gate cavity may be formed on one side of the device layer stack 103, resulting in that the gate cavity 142 will expose the device layer stack 103 along one sidewall of the device layer stack 103. The gate cavity 142 may be formed by a lithography and etching process. In other words, forming the gate cavity 142 may comprise etching the insulating layer 130 adjacent the device layer stack 103. As illustrated in Fig, 5, the patterned hard mask 120 may remain on the device layer stack 103 while forming the gate cavity 142. Alternatively, the patterned hard mask 120 may be removed while forming the gate cavity 142.

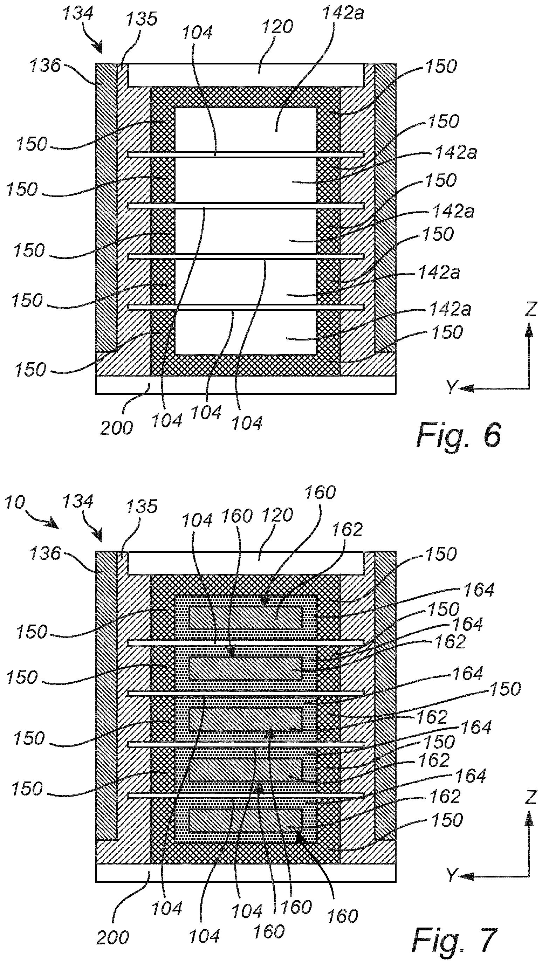

Now also turning to Fig. 6. Fig 6, schematically shows a cross sectional view through the device structure 100 of Fig. 5 along the Y-Z-plane as generally indicated by a hatched plane in Fig. 5. However, in Fig. 6, the device structure 100 has been subjected to a sequence of processing steps. The sacrificial layers 106 have been removed along the channel region 105. The sacrificial layers 106 may be removed along the channel region 105 by selectively etching the sacrificial material from the gate cavity 142. In other words, the sacrificial layers 106 may be accessed and selectively etched via the gate cavity 142. In this way, the gate cavity 142 may be extended into the device layer stack 103 between the source/drain contacts 134 such that an extended gate cavity 142a is formed. In other words, the extended gate cavity 142a may expose horizontally oriented surfaces of the channel layers and surface portions of the source/drain contacts facing the channel region 105. Thus, the channel layers 104 may be released.

Further, in Fig. 6, an inner spacer 150 has been formed. The inner spacer 150 may be formed by depositing an inner spacer material on interior surfaces exposed in the gate cavity 142 using an area selective deposition process, wherein surface portions of the channel layers 104 exposed in the gate cavity 142 define deposition-inhibiting areas for the selective deposition process. The inner spacer may be formed by ALD (e.g., thermal ALD or remote plasma ALD) or CVD. It has in this regard been demonstrated that ALD is highly selective with respect to the 2D material of the channel layers since the basal plane of a 2D material such as a TMD is virtually void of dangling bonds and substantially unreactive to precursors of the ALD process. In other words, by subjecting the exposed interior surfaces in the gate cavity 142 to an ALD process, the inner spacer material will predominantly or only deposit on other surfaces than the exposed surfaces of the 2D material channel layers 104 as illustrated in Fig. 6. In other words, the inner spacer 150 will grow from one or more of the contact metal layer 135, the hard mask 120 and the substrate 200 as illustrated in Fig. 6. Hence, by subjecting the exposed interior surfaces in the gate cavity 142 to an ALD process using an inner spacer material, the inner spacer material will not or in principle not grow from the 2D material channel layers 104. However, as illustrated in Fig. 6, the inner spacer 150 may grow from the contact metal layer 135 and hence extend onto the channel layers 104 as illustrated in Fig. 6. The inner spacer 104 may comprise Al₂O₃ or HfO₂ as a spacer material. Other lower permittivity spacer materials may be SiN, SiCN, SiCON, SiCO. The inner spacer 150 may be formed via an ALD process with trimethylaluminium (TMA) and H₂O.

Now also turning to Fig. 7. Fig. 7, schematically shows the same cross section as depicted in Fig. 6. However, in Fig. 7, the device structure 100 has been subjected to a sequence of processing steps. A gate stack 160 has been formed in the gate cavity 142. Hereby a 2D channel field-effect transistor device 10 is formed, although contacts have not yet been formed. As illustrated in Fig. 7, the gate stack 160 may be formed to surround the channel layers 104 along the channel region 105. Further, the gate stack 160 may as illustrated in Fig. 7 comprise a gate dielectric 164 and a gate metal layer 162. The gate dielectric 164 and a gate metal layer 162 may be conformally deposited in the gate cavity 142 as illustrated in Fig. 7. Alternatively, the gate stack 160 may comprise more than one gate metal layers 162. Further, the gate stack, 160 as illustrated in Fig. 7, may be laterally separated from the source/drain contacts 134 by the inner spacer 150. In other words, the gate stack 160 may be separated from the source/drain contacts 134 by the inner spacer 150 as seen along the channel direction, i.e. along the X-axis. The gate stack 160 may comprise a gate dielectric 164 and one or more gate metal layers. The gate dielectric 164 may comprise a high-k dielectric, such as HfO2, HfSiO, LaO, AIO or ZrO, and may be deposited by ALD. The one or more gate metal layers may comprise one or work function metals (e.g. Ti, TiAl, TiAlC, TiN, TaN, Mo, MoN, deposited by ALD), and a gate fill metal such as W, Mo, Al, Co or Ru. The gate fill metal may for instance be deposited by CVD, ALD or PVD. After deposition, the gate stack may be recessed by CMP and/or metal etch back to remove overburden metal, and thus arrive at the structure as shown in Fig. 7.

In the following alternative embodiments for forming a 2D channel field-effect transistor device 10 will be described with reference to Figs. 8-14. Initially, it will be described how a device structure 100 is formed with reference to Figs. 8-11. Subsequently, it will be described how a 2D channel field-effect transistor device 10 may be formed from the device structure 100. The alternative embodiments for forming a 2D channel field-effect transistor device 10 according to Figs. 8-14 are in many ways similar to embodiments described above in conjunction to Figs. 1-7. Therefore, in the following, mainly differences between the embodiments of Figs. 1-7 and Figs. 8-14 will be described in order to avoid undue repetition.

Now turning to Fig. 8. Fig. 8 shows, like Fig. 1 a perspective view of a pair of parallelly extending fin-shaped semiconductor structures 102 and a substrate 200. Each fin-shaped initial device layer stack 102 comprises an alternating sequence of channel layers 104 of a 2D material and sacrificial layers 106 of a sacrificial material. Unlike the fin-shaped initial device layer stack 102 of Fig. 1, the fin-shaped initial device layer stack 102 of Fig. 8 does not comprise a hard mask layer as a top layer. Further details regarding the fin-shaped initial device layer stack 102 are given above when describing Fig. 1.

Now turning also to Figs. 9a. Here it is depicted how the fin-shaped initial device layer stack 102 of Fig. 8 has been subjected to a sequence of processing steps. In Fig. 9a, a sacrificial gate structure 160 has been formed across the initial device layer stack 102. The sacrificial gate structure 160 may be formed by a deposition process and may comprise e.g. poly silicon or amorphous silicon. The sacrificial gate body 160 may be formed by depositing a sacrificial gate body material over the initial device layer stack 102 and subsequently patterning the sacrificial gate body 163. While the figures depict only one sacrificial gate structure 160 per initial device layer stack 102, it is to be understood that a multitude of parallel sacrificial gate structures 160 may be formed across each initial device layer stack 102. Conventional patterning techniques may be used, e.g. single patterning techniques such as lithography and etching ("litho-etch") or multiple-patterning techniques such as (litho-etch)", SADP or SAQP.

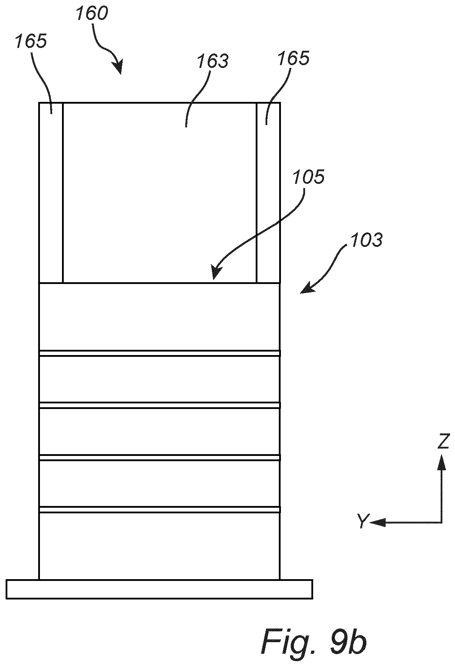

The sacrificial gate structure 160 comprises a sacrificial gate body 163. As per se is known in the art, the sacrificial gate body 163 may further be provided with a gate spacer 165, as schematically indicated in Fig 9b, and a gate hard mask, not shown, capping the sacrificial gate body 163. The gate spacer 165 may be formed on opposite sides of the sacrificial gate body 163. The gate spacer 165 may be formed by conformally depositing a gate spacer material and subsequently anisotropically etching the gate spacer material (e.g. top-down) to remove portions of the gate spacer material from horizontally oriented surfaces of the structure 102 and such that portions of the gate spacer material remain on the side surfaces of the sacrificial gate body 163 to form the gate spacer 165. The gate spacer 165 may be formed of dielectric material, e.g. as an oxide, a nitride or a carbide such as SiN, SiC, SiCO, SiCN or SiBCN deposited by ALD. In the following, the gate spacer 165 will be omitted for illustrational clarity.

In practice, the initial device layer stack 102 of Fig. 9a will undergo processing steps corresponding to those described above in conjunction with Figs. 2a and 2b although not illustrated in detail here. Thus, an insulating layer may typically be formed to embed the initial device layer stack 102 and the sacrificial gate structure 160. Further the initial device layer stack 102 may be subjected to a fin cut. Fig. 9b schematically shows a cross sectional view through the fin-shaped device layer stack 103 and the gate structure 160 of Fig. 9a along the Y-Z-plane generally indicated by a hatched plane in Fig. 9a after the fin cut has been performed. In other words, the cross-sectional view of Fig. 9b illustrates the initial device layer stack 102 after being subjected to the fin cut. As described above in conjunction with Fig. 2a, source/drain contact cavities are formed on either side of the channel region in the initial device layer stack 103 when performing the fin cut. When forming the source/drain contact cavities the sacrificial gate structure 160 may be used as an etch mask. In this way, a portion of the initial device layer stack 102 may remain in the channel region 105 to form the device layer stack 103.

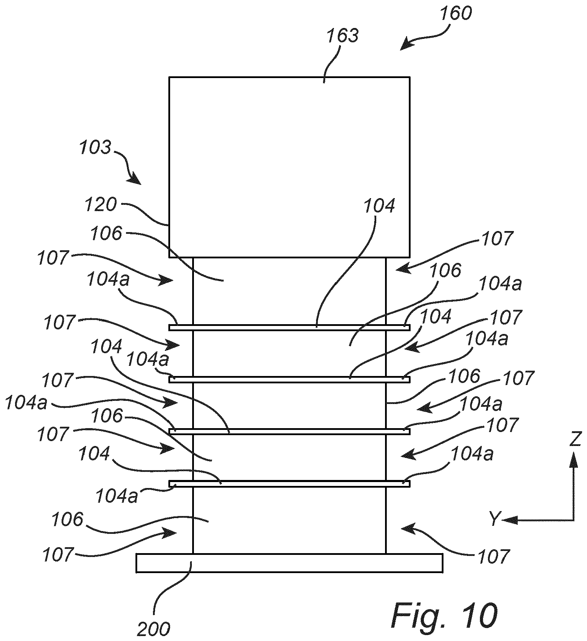

Now turning also to Fig. 10. Fig. 10 schematically shows the same cross section as depicted in Fig. 9b. However, in Fig. 10, the fin-shaped device layer stack 103 has been subjected to a further processing step, namely recesses 107 have been formed on either side in the device layer 103 stack. For further details regarding the formation of the recesses, reference is made to the above description of Fig. 3.

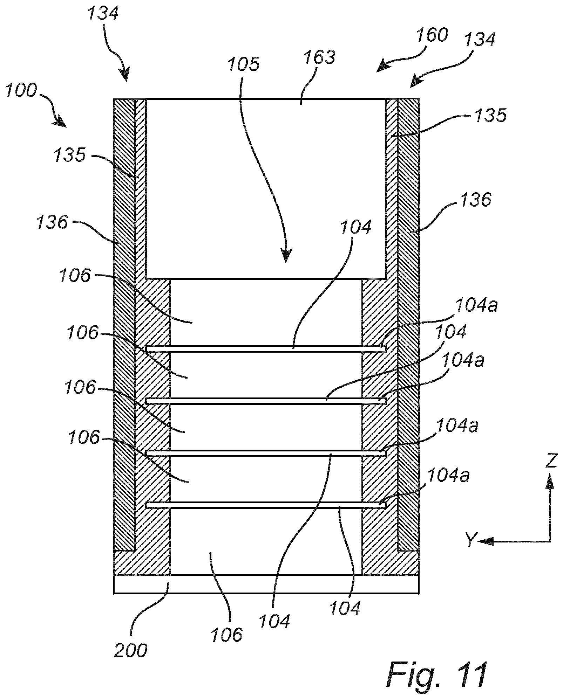

Now also turning to Fig. 11. Fig. 11, schematically shows the same cross section as depicted in Fig. 10. However, in Fig. 11 the fin-shaped device layer stack 103 has been subjected to further processing steps. In Fig. 11 source/drain contacts 134 have been formed in the source/drain cavities. For further details regarding the formation of source/drain contacts 134, reference is made to the above description of Fig. 4.

To sum up, Fig. 11 shows a device structure 100. The device structure 100 of Fig. 11 comprises the device layer stack 103. The device layer stack comprises an alternating sequence of channel layers 104 of a 2D material and sacrificial layers 106 of a sacrificial material. The device structure 100 of Fig. 11 further comprises the source/drain contacts 134. The source/drain contacts 134 are arranged in contact with the source/drain contact portions 104a of the channel layers 104 on either side of the channel region 105. Further, while not visible in the cross-sectional view of Fig. 11, the source/drain contacts 134 and the sacrificial gate structure 160 may be embedded or surrounded by an insulating layer corresponding to the insulating layer 130 shown in Fig. 2a. Furthermore, the sacrificial gate structure 160 has been formed across the device layer stack 103.

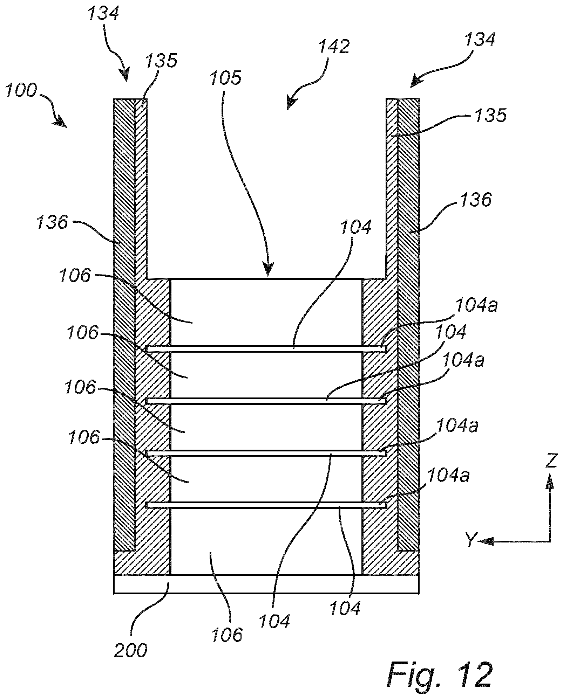

Now also turning to Fig. 12. Fig. 12, schematically shows the same cross section as depicted in Fig. 11. However, in Fig. 12 the device structure 100 has been subjected to further processing steps. In Fig. 12 the gate body 163 of the sacrificial gate structure 160 has been removed. The gate body 163 of the sacrificial gate structure 160 may be removed by a suitable etch process. By removing the gate body 163 of the sacrificial gate structure 160 the gate cavity 142 is formed. As have been described above in conjunction to Fig. 5, the gate cavity 142 exposes the channel layers 104 and the sacrificial layers 106 along the channel region 105.

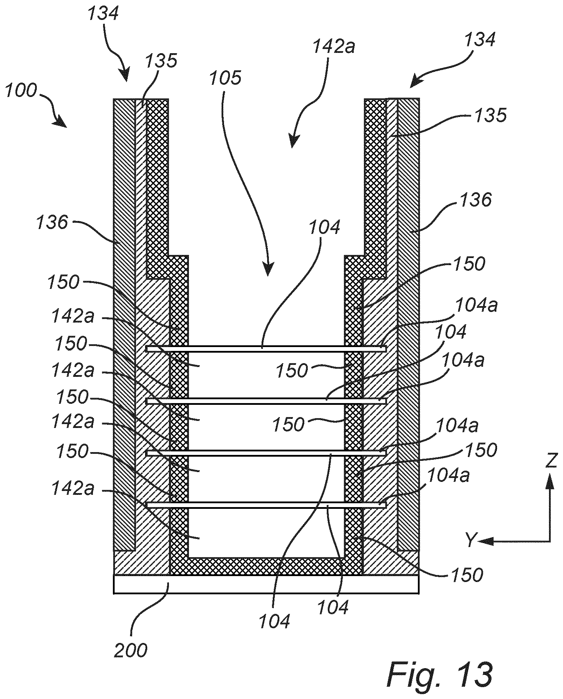

Now also turning to Fig. 13. Fig. 13, schematically shows the same cross section as depicted in Fig. 12. However, in Fig. 13 the device structure 100 has been subjected to further processing steps. In Fig. 13, the sacrificial layers 106 have been removed along the channel region 105. As have been described above in conjunction with Fig. 6, the sacrificial layers 106 may be removed along the channel region 105 by selectively etching the sacrificial material from the gate cavity 142 to form the extended gate cavity 142a. For further details regarding the removal of the sacrificial layers 106, reference is made to the above description of Fig. 6.

Further, in Fig. 13, an inner spacer 150 has been formed. The inner spacer 150 may be formed by depositing an inner spacer material on interior surfaces exposed in the gate cavity 142 using an area selective deposition process, wherein surface portions of the channel layers 104 exposed in the gate cavity 142 define deposition-inhibiting areas for the selective deposition process. For further details regarding the formation of the inner spacer 150, reference is made to the above description of Fig. 6.

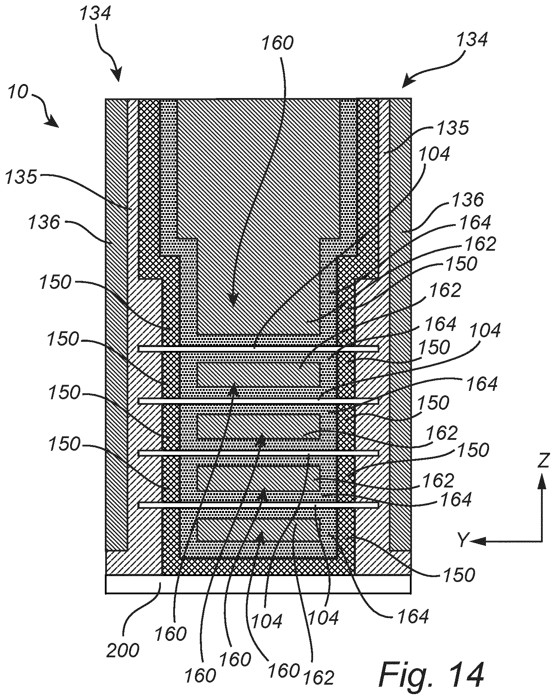

Now also turning to Fig. 14. Fig. 14, schematically shows the same cross section as depicted in Fig. 13. However, in Fig. 14 the device structure 100 has been subjected to further processing steps. In Fig. 14, a gate stack 160 has been formed in the gate cavity 142. Hereby a 2D channel field-effect transistor device 10 is formed, although contacts have not yet been formed. For further details regarding the formation of the inner spacer 150, reference is made to the above description of Fig. 7.

The person skilled in the art realizes that the present invention by no means is limited to the embodiments described above. On the contrary, many modifications and variations are possible within the scope of the appended claims.

## Claims

1. A method for forming a 2D channel field-effect transistor device (10), the method comprising:
forming a device structure (100) comprising:
a device layer stack (103) comprising a channel layer (104) of a 2D material and a pair of sacrificial layers (106) of a sacrificial material, wherein the channel layer (104) is arranged between the pair of sacrificial layers (106),
source/drain contacts (134) in contact with source/drain contact portions (104) of the channel layer (104) on either side of a channel region (105), and
an insulating layer (130) embedding the device layer stack (103) and the source/drain contacts (134);
forming a gate cavity (142) exposing the channel layer (104) and the sacrificial layers (106) along the channel region (105);
removing the sacrificial layers (106) along the channel region (105) by selectively etching the sacrificial material from the gate cavity (142), thereby extending the gate cavity (142) into the device layer stack (103) between the source/drain contacts;
forming an inner spacer (150) by depositing an inner spacer material on interior surfaces exposed in the gate cavity (142) using an area selective deposition process, wherein surface portions (104b) of the channel layer (104) exposed in the gate cavity (142) define deposition-inhibiting areas for the selective deposition process; and
forming a gate stack (160) in the gate cavity (142), the gate stack (160) surrounding the channel layer (104) along the channel region (105) and comprising a gate dielectric (164) and one or more gate metal layers (162), wherein the gate stack (160) is laterally separated from the source/drain contacts (134) by the inner spacer (150).

2. The method according to claim 1, further comprising forming recesses (107) in the device layer stack (103) by laterally etching back the sacrificial layers (106) from opposite sides of the channel region (105) prior to forming the source/drain contacts (134).

3. The method according to any one of the preceding claims, wherein the gate cavity (142) exposes the device layer stack (103) along one sidewall, or two opposite sidewalls, of the device layer stack (103).

4. The method according to any one of the preceding claims, wherein the device structure (100) further comprises a sacrificial gate body (163) extending across the device layer stack (103) in the channel region (105), wherein forming the gate cavity (142) comprises removing the sacrificial gate body (163).

5. The method according to any one of claims 1-4, wherein forming the gate cavity (142) comprises etching the insulating layer (130) adjacent the device layer stack (103).

6. The method according to claim 4, wherein forming the device structure (100) comprises:
forming a fin-shaped initial device layer stack (102) comprising a channel layer (104) of the 2D material and a pair of sacrificial layers (106) of the sacrificial material, wherein the channel layer (104) is arranged between the pair of sacrificial layers (106);
forming a sacrificial gate structure (160) across the initial device layer stack (102), the sacrificial gate structure (160) comprising the sacrificial gate body (163);
forming source/drain contact cavities (132) on either side of the channel region (105) using the sacrificial gate structure (160) as an etch mask such that a portion of the initial device layer stack (102) remains in the channel region (105) to form the device layer stack (103); and
forming the source/drain contacts (134) in the source/drain cavities (132).

7. The method according to claim 5, wherein forming the device structure (100) comprises:
forming a fin-shaped initial device layer stack (102) comprising a channel layer (104) of the 2D material and a pair of sacrificial layers (106) of the sacrificial material, and a hard mask (120) as a top layer, wherein the channel layer (104) is arranged between the pair of sacrificial layers (106);
forming the insulating layer (130) to embed the initial device layer stack (103);
patterning the hard mask (120) to open the hard mask on either side of the channel region (105);
forming source/drain contact cavities (132) on either side of the channel region (150) using the patterned hard mask (120) as an etch mask such that a portion of the initial device layer stack (102) remains in the channel region (105) to form the device layer stack (103); and
forming the source/drain contacts (134) in the source/drain cavities (132).

8. The method according to claim 7, wherein forming the gate cavity (142) further comprises removing the patterned hard mask (120).

9. The method according to claim 7, wherein the patterned hard mask (120) remains on the device layer stack (103) while forming the gate cavity (142).

10. The method according to any one of the preceding claims, wherein the 2D material is a transition metal dichalcogenide.
